# EUROPEAN PATENT APPLICATION

(11) **EP 4 733 454 A1**
(43) Date of publication of application: **29.04.2026**
(21) Application number: 24847880.2
(22) Date of filing: 25.06.2024
(51) Int. Cl.: C30B 31/06, C23C 16/40, C23G 5/06

(54) **PREPARATION METHOD FOR N-TYPE TOPCON CELL, AND N-TYPE TOPCON CELL**

(30) Priority: 31.07.2023 CN 202310949674
(71) Applicant: Jiangsu Runergy Century Photovoltaic Technology Co., Ltd., Yancheng, Jiangsu 224000 (CN)
(72) Inventor: YUE, Xiongying, Yancheng, Jiangsu 224000 (CN); LIU, Yinsheng, Yancheng, Jiangsu 224000 (CN); CHEN, Rulong, Yancheng, Jiangsu 224000 (CN); YANG, Yang, Yancheng, Jiangsu 224000 (CN); TAO, Longzhong, Yancheng, Jiangsu 224000 (CN)
(74) Representative: Schmid, Nils T.F.
(86) International application number: PCT/CN2024/101348
(87) International publication number: WO 2025/025919

(57) **Abstract**

An N-type TOPCon cell and a preparation method therefor. The method comprises: step 1, using an alkaline solution to perform texturing on an N-type silicon wafer; step 2, performing boron diffusion and laser micro-doping on a front face of the N-type silicon wafer, so as to form a micro-doped region, and then performing diffusion to form a front-face mask; step 3, performing a polishing treatment on a back face of the N-type silicon wafer; step 4, performing three-in-one multi-layer thin film deposition on the back face of the N-type silicon wafer, so as to grow a tunneling silicon oxide thin film layer, a doped amorphous silicon thin film layer and a back-face mask; step 5, performing high-temperature annealing under preset high-temperature conditions, so as to form a doped polycrystalline silicon layer and to activate doping phosphorus; step 6, cleaning the front-face mask on the front face of the N-type silicon wafer and the back-face mask on the back face of the N-type silicon wafer; step 7, depositing passivation films on the front face and back face of the N-type silicon wafer; and step 8, performing printing and sintering.

## Description

### TECHNICAL FIELD

The present disclosure relates to the technical field of crystalline silicon solar cell processing, and specifically relates to a preparation method for an N-type tunnel oxide passivated contact (TOPCon) cell and an N-type TOPCon cell.

### BACKGROUND

At present, with the gradual consumption of fossil energy, the development of renewable clean energy such as solar energy has become a development trend, where the solar cell is an electronic device for converting solar energy into electric energy by means of the photovoltaic effect.

In some existing art, the conversion efficiency of the cell cannot be further improved significantly, which is not beneficial to the requirement of continuously reducing the production cost in the photovoltaic industry. Therefore, how to simplify the process flow and improve the conversion efficiency of the photovoltaic cell is an urgent problem to be solved.

### SUMMARY

To achieve the above object, the present disclosure provides a preparation method for an N-type TOPCon cell, including: step 1: texturing an N-type silicon wafer with an alkaline solution, so that weight reduction of the N-type silicon wafer is controlled between 0.25g and 0.45g, and a surface reflectivity of the silicon wafer is controlled between 7% and 10%; step 2: performing boron diffusion and laser lightly-doping on a front face of the N-type silicon wafer to form a lightly-doped region, and performing re-diffusion to form a front mask; step 3: polishing a back face of the N-type silicon wafer; step 4: performing three-in-one multi-layer thin film deposition on the back face of the N-type silicon wafer, to grow a tunneling silicon oxide thin film layer, a doped amorphous silicon thin film layer and a back mask, where the tunneling silicon oxide thin film layer has a thickness less than 2nm, the amorphous silicon thin film layer has a thickness between 50nm and 200nm, and the back mask has a thickness between 5nm and 30nm; step 5: performing high-temperature annealing under a preset high-temperature condition to form a doped polysilicon layer and activate doped phosphorus; step 6: cleaning the front mask on the front face and the back mask on the back face of the N-type silicon wafer; step 7: depositing passivation films on the front face and the back face of the N-type silicon wafer; and step 8: printing and sintering.

The present disclosure further discloses a preparation method for an N-type TOPCon cell, including: texturing an N-type silicon wafer; performing boron diffusion and laser lightly-doping on a front face of the N-type silicon wafer to form a lightly-doped region; performing re-diffusion on the front face of the N-type silicon wafer to form a front mask; polishing a back face of the N-type silicon wafer; performing three-in-one multi-layer thin film deposition on the back face of the N-type silicon wafer, and growing a tunneling silicon oxide thin film layer, a doped amorphous silicon thin film layer and a back mask through one process step; performing high-temperature annealing under a preset high-temperature condition to form a doped polysilicon layer and activate doped phosphorus; cleaning the front mask on the front face and the back mask on the back face of the N-type silicon wafer; depositing passivation films on the front face and the back face of the N-type silicon wafer; and printing and sintering.

The present disclosure further discloses an N-type TOPCon cell, which is an N-type TOPCon cell being obtained by the preparation method for an N-type TOPCon cell according to the present disclosure.

### BRIEF DESCRIPTION OF DRAWINGS

FIG. 1 is a working flow chart according to the present disclosure.
FIG. 2 is a schematic structural view of a cleaning device according to the present disclosure.
FIG. 3 is a schematic structural view of a turbulent type cleaning unit according to the present disclosure.
FIG. 4 is an enlarged view of A portion in FIG. 3.
FIG. 5 is a schematic view showing internal structures of a fixing component according to the present disclosure.
FIG. 6 is a schematic structural view of a cell according to the present disclosure.

List of reference signs:
1. N-type silicon wafer; 3. lightly-doped region; 4. aluminum oxide film; 5. front silicon nitride film; 6. silver-aluminum grid lines; 7. tunneling silicon oxide thin film layer; 8. polysilicon layer; 9. back passivation film; 10. silver grid lines; 11. ultrasonic cleaning tank; 12. silicon wafer holder; 13. cleaning seat; 14. notch; 15. movable beam; 16. movable trolley; 17. track; 18. drive motor; 19. drum; 20. scroll plate; 21. fan-shaped fixing seat; 22. limit plate; 23. action chamber; 24. central rod; 25. side connecting rod; 26. clamping rod; 27. engaging block; 28. side mounting shell; 29. bolt; 30. swivel nut; 31. bottom connecting seat; 32. spring rod; 33. engaging slot; 34. rotatable rod; 35. bow-shaped mounting bracket; and 36. paddle.

### DETAIL DESCRIPTION OF EMBODIMENTS

The technical solutions of the present disclosure will be described cleanly and completely below with reference to the accompanying drawings. Obviously, the described embodiments are part, but not all, of the embodiments of the present disclosure. Based on the embodiments of the present disclosure, all other embodiments obtained by those ordinary skilled in the art without any creative effort fall into the protection scope of the present disclosure.

### First embodiment

The present disclosure will be further described below with reference to the accompanying drawings.

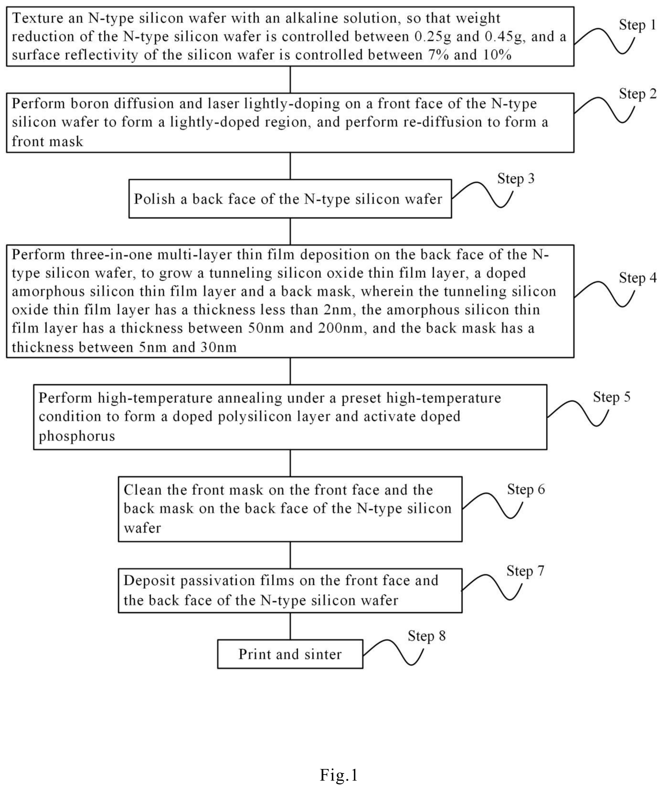

As shown in FIGs. 1 to 6, this embodiment provides a preparation method for an N-type TOPCon cell, which includes the following steps 1 to 8. Step 1 includes: texturing an N-type silicon wafer with an alkaline solution, so that weight reduction of the N-type silicon wafer is controlled between 0.25g and 0.45g, and a surface reflectivity of the silicon wafer is controlled between 7% and 10%. Step 2 includes: performing boron diffusion and laser lightly-doping on a front face of the N-type silicon wafer to form a lightly-doped region, and performing re-diffusion to form a front mask. Step 3 includes: polishing a back face of the N-type silicon wafer. Step 4 includes: performing three-in-one multi-layer thin film deposition on the back face of the N-type silicon wafer, to grow a tunneling silicon oxide thin film layer, a doped amorphous silicon thin film layer and a back mask, where the tunneling silicon oxide thin film layer has a thickness less than 2nm, the amorphous silicon thin film layer has a thickness between 50nm and 200nm, and the back mask has a thickness between 5nm and 30nm. Step 5 includes: performing high-temperature annealing under a preset high-temperature condition to form a doped polysilicon layer and activate doped phosphorus. Step 6 includes: cleaning the front mask on the front face and the back mask on the back face of the N-type silicon wafer. Step 7 includes: depositing passivation films on the front face and the back face of the N-type silicon wafer. Step 8 includes: printing and sintering.

The working principle and beneficial effects of the above technical solution are as follows: the present disclosure provides a preparation method for an N-type TOPCon cell, including: texturing an N-type silicon wafer 1, performing boron diffusion and laser lightly-doping on an emitter, performing re-diffusion to form a front mask, polishing a back face of the N-type silicon wafer, three-in-one coating (growing a tunneling silicon oxide thin film layer, a doped amorphous silicon thin film layer and a back mask on the back face of the cell, where the three film layers are deposited in the same device), annealing, cleaning the front and back masks, depositing passivation films on the front and back faces, and printing and sintering to form the cell. The preparation method for an N-type TOPCon cell provided in the present disclosure can preparing a tunneling silicon oxide thin film layer and an amorphous silicon thin film layer in one step without a more complex process of forming a tunneling silicon oxide thin film layer by tubular oxidation first and then doping, which greatly simplifies the process flow. In addition, laser lightly-doping and re-diffusion are performed after boron diffusion in the present disclosure, so that the doping condition in an emitter region can be greatly improved, and the cell efficiency can be increased.

The preparation method for an N-type TOPCon cell provided in the present disclosure makes full use of the characteristics of plasma enhanced chemical vapor deposition (PECVD) which allow single-side coating and flexible growth of various thin films within a single cavity, and completes formation of the mask layers contacting the passivation structure film layer and the cell in one process step, thereby effectively reducing the process steps and the consumption of silver paste, while increasing the efficiency of the cell.

The three-in-one coating specifically includes: performing three-in-one multi-layer thin film deposition on the back face of the N-type silicon wafer with a single-side deposited PECVD tubular or plate type device, to grow a tunneling silicon oxide thin film layer, a doped amorphous silicon thin film layer and a back mask, where the tunneling silicon oxide thin film layer has a thickness less than 2nm, the doped amorphous silicon thin film layer is an in situ phosphorus-doped thin film with a thickness between 50nm and 200nm, and the back mask has a thickness between 5nm and 30nm and is made of any one of SiONx, SiOx or SiNx.

With the three-in-one coating process described above, the following beneficial effects are achieved: (1) the growth of the tunneling silicon oxide thin film layer, the doped amorphous silicon thin film layer and the back mask on the back of the cell is completed in one step, which has advantages compared with the case in some existing arts where a tunneling silicon oxide thin film, an intrinsic polycrystalline silicon thin film, and a silicon nitride thin film are deposited in different devices; (2) the number of automatic actions such as loading and unloading are reduced during preparation of the cell, which can greatly increase the preparation yield; and (3) completing in one step reduces heating/cooling processes during preparation of the cell, thereby reducing the influence on the efficiency of the cell.

In one embodiment, in the step 1, the texturing on the N-type silicon wafer 1 is implemented with a KOH or NaOH solution with a mass fraction of 40% to 60% at a temperature between 60°C and 80°C for 400s to 600s.

In one embodiment, in step 2, the process of performing re-diffusion to form the front mask includes: loading the textured N-type silicon wafer into a quartz boat, and pushing the quartz boat into a diffusion furnace quartz furnace tube with an internal temperature between 800°C and 900°C, where the diffusion furnace quartz furnace tube adopts a low-pressure diffusion mode; introducing O₂ at a flow rate of 1000sccm to 5000sccm, and performing pre-oxidation for 100s to 500s before deposition; heating up to 850°C to 900°C, and vacuumizing by a vacuum pump to enable a low-pressure state of the diffusion furnace quartz furnace tube at an atmosphere below 100mbar; introducing BCl₃ at a flow rate of 50sccm to 500sccm and O₂ at a flow rate of 200sccm to 2000sccm to perform first boron source deposition for 100s to 500s; introducing BCl₃ at a flow rate of 60sccm to 600sccm and O₂ at a flow rate of 300sccm to 3000sccm to perform second boron source deposition for 100s to 500s; heating up to 950°C to 1050°C, and performing driving in for 500s to 2000s; introducing 1L to 10L of nitrogen to provide a back pressure when the driving in is finished; cooling and discharging: taking the quartz boat out of the diffusion furnace quartz furnace tube when the temperature is reduced to 700°C to 800 °C; and wafer removal: removing the silicon wafer from the quartz boat; where a sheet resistance is controlled between 90Ω/m and 160Q/m.

In one embodiment, in the laser lightly-doping process in step 2, a laser device uses boron atoms formed by diffusion in processing of a printed grid line region to form a lightly-doped region. A laser wavelength is controlled between 500nm and 1100nm, a laser power is controlled between 30W and 100W, a laser processing speed is between 10m/s and 50m/s, a laser width acting on the printed grid line region is between 50µm and 100µm, and a laser lightly-doped region has a sheet resistance between 70Ω/m and 120Q/m.

The process of performing re-diffusion to form the front mask includes: loading the textured N-type silicon wafer into a quartz boat, and pushing the quartz boat into a diffusion furnace quartz furnace tube with an internal temperature between 950°C and 1100°C, where the diffusion furnace quartz furnace tube adopts a low-pressure diffusion mode, and vacuumizing by a vacuum pump to enable a low-pressure state of the diffusion furnace quartz furnace tube at an atmosphere below 100mbar; introducing O₂ at a flow rate of 10000sccm to 50000sccm and depositing for 3000s to 6000s, and performing oxidation to form a front mask with a thickness between 60nm and 120nm; introducing 1L to 20L of nitrogen when the forming a front mask is finished to provide a back pressure; cooling and discharging: taking the quartz boat out of the diffusion furnace quartz furnace tube when the temperature is reduced to 700°C to 800°C; and wafer removal: removing the silicon wafer from the quartz boat.

In one embodiment, in step 3, 2 to 3 parts of alkali metal hydroxide solution with a mass fraction of 40% to 60% and 1 part of polishing additive are used to polish the back face of the N-type silicon wafer at a temperature between 50°C and 70°C for 100s to 300s; and a lightly-doped region 3 on the front face of the N-type silicon wafer is protected by the front mask from being polished.

In one example, in step 4, laughing gas at a flow rate of 5000sccm to 15000sccm is introduced into a tubular PECVD furnace with a low-frequency power of 20KHz to 50KHz at a temperature between 300°C and 500°C, and ionized into plasma to oxidize the back face of the N-type silicon wafer to form a silicon dioxide layer with a thickness controlled between 0.5nm and 2.5nm; and in the process of depositing the doped amorphous silicon thin film layer on the back face, a tubular PECVD furnace with a low-frequency power of 20KHz to 50KHz is at a temperature between 300°C and 500°C, and has silane at a flow rate of 500sccm to 5000sccm and phosphane at a flow rate of 100sccm to 5000sccm, while hydrogen is introduced simultaneously as a catalyst gas for preparation of the doped amorphous silicon thin film layer, where the phosphorus doping concentration is between 1E19/cm³ and 1E21/cm³, and the doped amorphous silicon thin film layer has a thickness between 20nm and 200nm.

In one embodiment, in the process of preparing the back mask in step 4, laughing gas at a flow rate of 2000sccm to 10000sccm, and silane at a flow rate of 500sccm to 5000sccm, are introduced into a tubular PECVD furnace with a low-frequency power of 20KHz to 50KHz at a temperature between 300°C and 500°C, and subjected to plasma deposition to form a back mask with a thickness controlled between 3nm to 8nm.

In one embodiment, a tunneling silicon oxide thin film layer 7, a polysilicon layer 8, and the back mask are formed in the same process step by PECVD.

In one embodiment, in step 5, nitrogen is introduced and high-temperature annealing is performed under a high-temperature condition to form a doped polysilicon layer and activate doped phosphorus, where a flow rate of the nitrogen is controlled between 10000sccm to 50000sccm, and the high-temperature annealing is performed at 800°C to 1000°C for 3000s to 6000s.

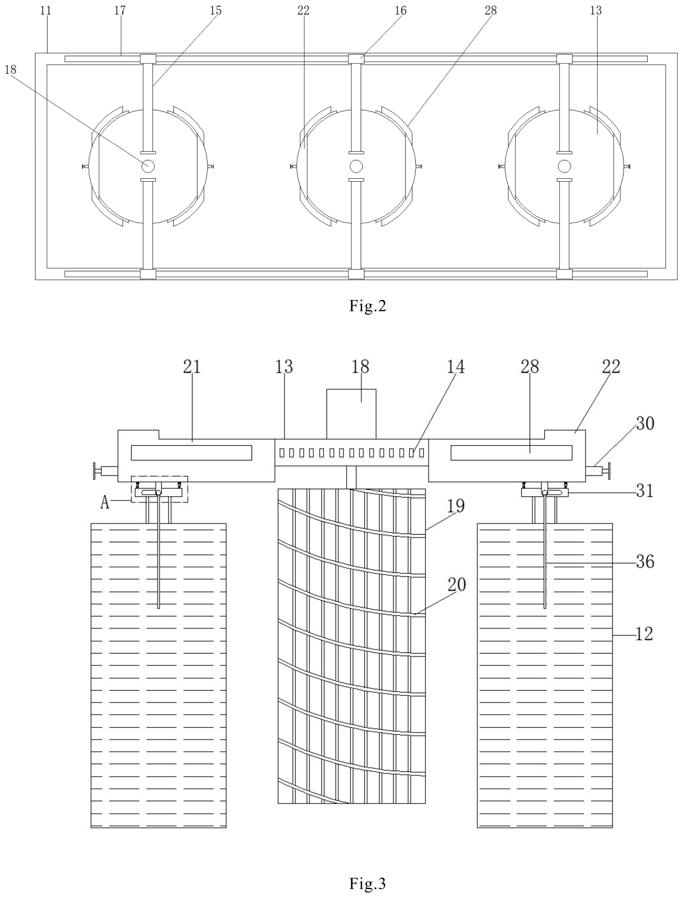

In one embodiment, in step 6, an HF solution with a mass fraction of 30% to 60% is used in a cleaning device for cleaning at a temperature between 20°C to 50°Cto remove the front mask on the front face and the back mask on the back face of the N-type silicon wafer, where the cleaning is performed for 100s to 500s. As shown in FIGs. 2 and 3, the cleaning device includes an ultrasonic cleaning tank 11, a plurality of turbulent type cleaning units are removably disposed at an opening end of the ultrasonic cleaning tank 11, and two silicon wafer holders 12 are disposed oppositely on each turbulent type cleaning unit through fixing components.

The working principle and beneficial effects of the above technical solution include: placing silicon wafers into a silicon wafer holder 12, holding a fixing component by a hand and disposing the fixing component on a turbulent type cleaning unit, filing an HF solution with a mass fraction of 30% to 60% into the ultrasonic cleaning tank 11, immerging the silicon wafer holder 12 in the HF solution, and operating the ultrasonic cleaning tank 11 and the turbulent type cleaning unit to cleaning and removing oxide layer masks on the front and back faces of the silicon wafer rapidly.

In one embodiment, as shown in FIGs. 2 and 3, each turbulent type cleaning unit includes: a cleaning seat 13, including: notches 14 uniformly arranged at a side end of the cleaning seat 13 for easy engagement of the fixing components, movable beams 15 arranged symmetrically at a top end of the cleaning seat 13, a movable trolley 16 disposed at an end of each movable beam 15 away from the cleaning seat 13, and a track 17 for easy movement of the movable trolley 16 and disposed at the opening end of the ultrasonic cleaning tank 11; a drive motor 18 disposed at the top end of the cleaning seat 13; and a drum 19 opened at a bottom end; where an output end of the drive motor 18 passes through the cleaning seat 13 to be connected to a top end of the drum 19, and a surface of the drum 19 is provided with hollow holes uniformly distributed and scroll plates 20 spirally arranged.

The working principle and beneficial effects of the above technical solution include: operating the movable trolley 16 so that the movable beam 15 drives the cleaning seat 13 to move along the track 17 in the ultrasonic cleaning tank 11, and thus uniform distribution of the silicon wafer holder 12 in the ultrasonic cleaning tank 11 is achieved; operating the drive motor 18to drive the drum 19 at the output end of the drive motor 18 to rotate at the bottom end of the cleaning seat 13, so that the scroll plates 20 on the surface of the drum 19 drives the HF solution to rotate in a vortex manner to flush silicon wafers placed in the silicon wafer holder 12, thereby cleaning and removing oxide layer masks on the front and back faces of the silicon wafer rapidly.

In one embodiment, as shown in FIGs. 3, 4 and 5, each fixing component includes: a fan-shaped fixing seat 21, where an engaging slot is provided on a top end of the fan-shaped fixing seat 21 for easy engagement of the side end of the cleaning seat 13, a limit plate 22 covers an opening end of the engaging slot and is engaged with the top end of the cleaning seat 13, and each silicon wafer holder 12 is disposed at a bottom end of the fan-shaped fixing seat 21 through the corresponding connecting component; an action chamber 23 in the fan-shaped fixing seat 21 and consisting of a bottom chamber and side chambers, where the bottom chamber is located at a bottom of the engaging slot, two side chambers are symmetrically arranged taking the engaging slot as the center, and two side mounting shells 28 are symmetrically disposed on the fan-shaped fixing seat 21 and in communication with the side chambers; a central rod 24 in the bottom chamber and connected to the connecting component which extends into the bottom chamber; two side connecting rods 25 hinged at two ends of the central rod 24, respectively; a clamping rod 26 bent at an obtuse angle in each side chamber, where one end of the clamping rod 26 is rotatably disposed in the action chamber 23 through a rotation shaft, while the other end of the clamping rod 26 is provided with an engaging block 27 matched with the notches 14, and extends into the corresponding side mounting shell 28; and a bolt 29 extending from the fan-shaped fixing seat 21 into the bottom chamber away from the engaging slot, and rotatably disposed on the central rod 24, where a swivel nut 30 is sleeved on the bolt 29 and fixedly disposed on the fan-shaped fixing seat 21 at a position away from the engaging slot.

The working principle and beneficial effects of the above technical solution include: placing silicon wafers into a silicon wafer holder 12, holding the fan-shaped fixing seat 21 by a hand and engaging the fan-shaped fixing seat 21 at a side end of the cleaning seat 13 by the engaging slot, manually screwing the bolt 29 to drive the bolt 29 to rotate in the swivel nut 30 and pull the central rod 24 in the bottom chamber by the bolt 29 to move in a direction toward the swivel nut 30, so that the central rod 24 pulls the clamping rod 26 in the side chamber through the side connecting rod 25 to make the engaging block 27 on the clamping rod 26 engaged into a notch 14 in the side end of the cleaning seat 13, thereby fixing the fan-shaped fixing seat 21 onto the cleaning seat 13, and , when the silicon wafers are all washed, screwing the bolt 29 in an opposite direction to release the fan-shaped fixing seat 21 from the cleaning seat 13. At this time, the fan-shaped fixing seat 21 is manually pulled up to take the silicon wafer holder 12 out of the ultrasonic cleaning tank 11. In this manner, rapid assembly and disassembly of the fan-shaped fixing seat 21 and the cleaning seat 13 can be implemented.

In one embodiment, as shown in FIGs. 3, 4 and 5, each connecting component includes: a bottom connecting seat 31 having a top end hinged to a bottom end of the fan-shaped fixing seat 21 through two spring rods 32 symmetrically arranged, and a bottom end on which the corresponding silicon wafer holder 12 is disposed; an engaging slot 33 provided in and running through the bottom connecting seat 31; a rotatable rod 34 having a middle segment provided as a square rod fitly and slidably connected into the engaging slot 33, and two ends rotatably disposed on a bow-shaped mounting bracket 35 having an end away from the rotatable rod 34 extending into the bottom chamber and connected to the central rod 24; and paddles 36 vertically disposed at two ends of the rotatable rod 34.

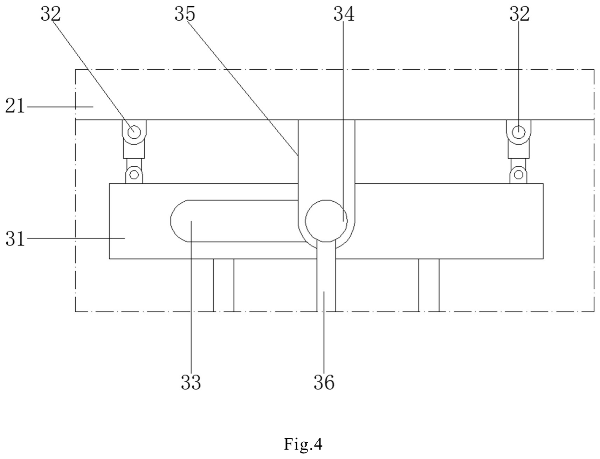

The working principle and beneficial effects of the above technical solution are as follows: to fix the fan-shaped fixing seat 21 onto the cleaning seat 13, the bolt 29 is manually screwed to drive the bolt 29 to rotate in the swivel nut 30 and pull the central rod 24 in the bottom chamber by the bolt 29 to move in a direction toward the swivel nut 30, so that the central rod 24 drives the bow-shaped mounting bracket 35 connected thereto and the rotatable rod 34 on the bow-shaped mounting bracket 35 to move in a direction toward the swivel nut 30; as shown in FIG. 4, the rotatable rod 34 in the engaging slot 33 moves toward a left end of the engaging slot 33 so that the rotatable rod 34 is eccentrically located at the left end of the engaging slot 33, the drum 19 at the output end of the drive motor 18 rotates at the bottom end of the cleaning seat 13, so that the scroll plates 20 on the surface of the drum 19 drives the HF solution to rotate in a vortex manner to flush silicon wafers placed in the silicon wafer holder 12, and flush the paddles 36 vertically disposed on both ends of the rotatable rod 34 to drive the rotatable rod 34 to rotate on the bow-shaped mounting bracket 35; since the middle segment of the rotatable rod 34 is provided as a square rod, the rotating rotatable rod 34 cooperates with the engaging slot 33 to drive the bottom connecting seat 31 to flip by a small angle in a direction away from the drum 19; that is, the spring rod 32 at the right end of the bottom connecting seat 31 is stretched, while the spring rod 32 at the left end of the bottom connecting seat 31 is contracted, so as to achieve oscillation of the bottom connecting seat 31 at a small angle and accelerate removal of the oxidation layers on the front and back faces of the silicon wafer.

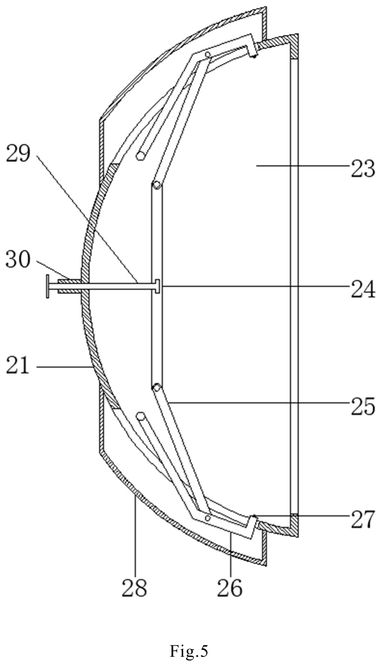

In one embodiment, as shown in FIG. 5, a puller is provided on the limit plate 22, and a rotatable handle is provided on the bolt 29.

In one embodiment, in step 7, the passivation film deposited on the front face is a front passivation film consisting of an aluminum oxide film 4 and a front silicon nitride film 5 in superposition. The aluminum oxide passivation film is deposited by an autocatalytic reaction of trimethylaluminum and water, and has a thickness controlled between 3nm to 15nm; the silicon nitride passivation film is formed by ionization deposition of silane and ammonia in a PECVD manner, and the thickness of the front passivation film is controlled between 60nm to 100nm. The passivation film deposited on the back face is a back passivation film 9 consisting of a back silicon nitride film, and has a thickness controlled between 70nm to 110nm.

In one embodiment, in step 8, silver aluminum paste printed positive electrode silver-aluminum grid lines 6 are used on the front face of the N-type silicon wafer, while silver paste printed negative electrode silver grid lines 10 are used on the back face of the N-type silicon wafer, and then drying and sintering are performed to form an N-type TOPCon cell. The silver aluminum paste can form good metal contact with the lightly-doped region, while the silver paste can be sintered into a polysilicon layer to form good passivation metal contact, where the sintering temperature is between 500°C to 900°C.

### Second embodiment

As shown in FIGs. 1 to 6, this embodiment provides a preparation method for an N-type TOPCon cell, including: texturing an N-type silicon wafer; performing boron diffusion and laser lightly-doping on a front face of the N-type silicon wafer to form a lightly-doped region; performing re-diffusion on the front face of the N-type silicon wafer to form a front mask; polishing a back face of the N-type silicon wafer; performing three-in-one multi-layer thin film deposition on the back face of the N-type silicon wafer, and growing a tunneling silicon oxide thin film layer, a doped amorphous silicon thin film layer and a back mask through one process step; performing high-temperature annealing under a preset high-temperature condition to form a doped polysilicon layer and activate doped phosphorus; cleaning the front mask on the front face and the back mask on the back face of the N-type silicon wafer; depositing passivation films on the front face and the back face of the N-type silicon wafer; and printing and sintering.

The preparation method for an N-type TOPCon cell of this embodiment can prepare a tunneling silicon oxide thin film layer, an amorphous silicon thin film layer and a back mask in one process step, which greatly simplifies the process flow. In this embodiment, by performing boron diffusion, laser lightly-doping and re-diffusion sequentially on the front face of the N-type silicon wafer, the doping condition in an emitter region can be greatly improved, and the cell efficiency can be increased.

In one embodiment, the tunneling silicon oxide thin film layer has a thickness less than 2nm; the doped amorphous silicon thin film layer is an in situ phosphorus-doped thin film with a thickness between 50nm and 200nm; and the back mask has a thickness between 5nm and 30nm and is made of any one of SiONx, SiOx or SiNx.

By preparing the tunneling silicon oxide thin film layer, the amorphous silicon thin film layer and the back mask in one process step, this embodiment achieves the following beneficial effects: (1) a simplified process flow; (2) reduced the number of automatic actions such as loading and unloading during preparation of the cell, which can greatly increase the preparation yield; and (3) reduced heating/cooling processes during preparation of the cell, thereby reducing the influence on the efficiency of the cell.

In one embodiment, the process of texturing the N-type silicon wafer is implemented with a KOH or NaOH solution with a mass fraction of 40% to 60% at a temperature between 60°C and 80°C for 400s to 600s.

After the texturing, weight reduction of the N-type silicon wafer is controlled between 0.25g and 0.45g, and a surface reflectivity of the silicon wafer is controlled between 7% and 10%.

In one embodiment, the process of performing re-diffusion to form the front mask includes: introducing O₂ at a flow rate of 1000sccm to 5000sccm into an environment with a temperature between 800°C and 900°C to pre-oxidize the N-type silicon wafer for 100s to 500s; introducing BCl₃ at a flow rate of 50sccm to 500sccm and O₂ at a flow rate of 200sccm to 2000sccm into an environment with a temperature between 850°C and 900°C and an atmosphere below 100mbar, to perform first boron source deposition for 100s to 500s; introducing BCl₃ at a flow rate of 60sccm to 600sccm and O₂ at a flow rate of 300sccm to 3000sccm to perform second boron source deposition for 100s to 500s; performing driving in for 500s to 2000s in an environment with a temperature between 950°C and 1050°C; and introducing 1L to 10L of nitrogen to provide a back pressure. cooling and discharging: taking out the quartz boat when with the N-type silicon wafer the temperature is reduced to 700°C to 800°C; and wafer removal: removing the N-type silicon wafer from the quartz boat.

In one embodiment, the laser lightly-doping process includes: performing laser lightly-doping processing on a printed grid line region with boron atoms formed by diffusion, to form a lightly-doped region, where a laser wavelength is between 500nm and 1100nm, a laser power is between 30W and 100W, a laser processing speed is between 10m/s and 50m/s, a laser width acting on the printed grid line region is between 50µm and 100µm, and a laser lightly-doped region has a sheet resistance between 70Ω/m and 120Ω/m.

The process of performing re-diffusion to form the front mask includes: introducing O₂ at a flow rate of 10000sccm to 50000sccm into an environment with a temperature between 950°C and 1100 °C and an atmosphere below 100mbar, and depositing for 3000s to 6000s to form the front mask; and introducing 1L to 20L of nitrogen to provide a back pressure; cooling and discharging: taking out the quartz boat when with the N-type silicon wafer the temperature is reduced to 700°C to 800°C; and wafer removal: removing the N-type silicon wafer from the quartz boat.

In one embodiment, the process of polishing the back face of the N-type silicon wafer includes: polishing the back face of the N-type silicon wafer with 2 to 3 parts of alkali metal hydroxide solution with a mass fraction of 40% to 60% and 1 part of polishing additive, where the polishing is performed at a temperature between 50°C and 70°C for 100s to 300s.

In one embodiment, the process of growing the tunneling silicon oxide thin film layer, the doped amorphous silicon thin film layer and the back mask through one process step includes: preparing a tunneling silicon oxide thin film layer, a doped amorphous silicon thin film layer and a back mask in one process step by PECVD.

In this embodiment, the PECVD device may be a PECVD tubular device or a PECVD plate type device.

In this embodiment, by preparing the tunneling silicon oxide thin film layer, the doped amorphous silicon thin film layer and the back mask in one process step by PECVD, the characteristics of the PECVD device which allow single-side coating and flexible growth of various thin films within a single cavity are fully used, thereby effectively reducing the process steps and the consumption of silver paste, while increasing the efficiency of the cell.

In one embodiment, the process of preparing the tunneling silicon oxide thin film layer, the doped amorphous silicon thin film layer and the back mask in one process step by PECVD includes: introducing laughing gas at a flow rate of 5000sccm to 15000sccm into a PECVD device at a temperature between 300°C and 500°C, and ionizing the laughing gas into plasma to oxidize the back face of the N-type silicon wafer to form a tunneling silicon oxide thin film layer with a thickness between 0.5nm and 2.5nm; introducing hydrogen into the PECVD device at a temperature between 300°C and 500°C and having silane at a flow rate of 500sccm to 5000sccm and phosphane at a flow rate of 100sccm to 5000sccm, to form a doped amorphous silicon thin film layer, where the phosphorus doping concentration is between 1E19/cm³ and 1E21/cm³, and the doped amorphous silicon thin film layer has a thickness between 20nm and 200nm; and introducing laughing gas at a flow rate of 5000sccm to 15000sccm, and silane at a flow rate of 500sccm to 5000sccm into the PECVD device at a temperature between 300°C and 500°C, to form a back mask with a thickness controlled between 3nm to 8nm.

In one embodiment, in the process of performing high-temperature annealing under a preset high-temperature condition to form a doped polysilicon layer and activate doped phosphorus, nitrogen with a flow rate controlled between 10000sccm to 50000sccm is introduced, and the high-temperature annealing is performed at 800°C to 1000°C for 3000s to 6000s.

In one embodiment, the process of cleaning the front mask on the front face and the back mask on the back face of the N-type silicon wafer includes: using an HF solution with a mass fraction of 30% to 60% in a cleaning device for cleaning to remove the front mask on the front face and the back mask on the back face of the N-type silicon wafer, where the cleaning is performed at a temperature between 20°C and 50°C for 100s to 500s. As shown in FIGs. 2 and 3, the cleaning device includes an ultrasonic cleaning tank, a plurality of turbulent type cleaning units are removably disposed at an opening end of the ultrasonic cleaning tank, and two silicon wafer holders are disposed oppositely on each turbulent type cleaning unit.

In one embodiment, as shown in FIGs. 2 and 3, each turbulent type cleaning unit includes: a cleaning seat 13, including: notches 14 uniformly arranged at a side end of the cleaning seat 13 for easy engagement of the fixing components, movable beams 15 arranged symmetrically at a top end of the cleaning seat 13, a movable trolley 16 disposed at an end of each movable beam 15 away from the cleaning seat 13, and a track 17 for easy movement of the movable trolley 16 and disposed at the opening end of the ultrasonic cleaning tank 11; a drive motor 18 disposed at the top end of the cleaning seat 13; and a drum 19 opened at a bottom end; where an output end of the drive motor 18 passes through the cleaning seat 13 to be connected to a top end of the drum 19, and a surface of the drum 19 is provided with hollow holes uniformly distributed and scroll plates 20 spirally arranged.

In one embodiment, as shown in FIGs. 3, 4 and 5, each fixing component includes: a fan-shaped fixing seat 21, where an engaging slot is provided on a top end of the fan-shaped fixing seat 21 for easy engagement of the side end of the cleaning seat 13, a limit plate 22 covers an opening end of the engaging slot and is engaged with the top end of the cleaning seat 13, and each silicon wafer holder 12 is disposed at a bottom end of the fan-shaped fixing seat 21 through the corresponding connecting component; an action chamber 23 in the fan-shaped fixing seat 21 and consisting of a bottom chamber and side chambers, where the bottom chamber is located at a bottom of the engaging slot, two side chambers are symmetrically arranged taking the engaging slot as the center, and two side mounting shells 28 are symmetrically disposed on the fan-shaped fixing seat 21 and in communication with the side chambers; a central rod 24 in the bottom chamber and connected to the connecting component which extends into the bottom chamber; two side connecting rods 25 hinged at two ends of the central rod 24, respectively; a clamping rod 26 bent at an obtuse angle in each side chamber, where one end of the clamping rod 26 is rotatably disposed in the action chamber 23 through a rotation shaft, while the other end of the clamping rod 26 is provided with an engaging block 27 matched with the notches 14, and extends into the corresponding side mounting shell 28; and a bolt 29 extending from the fan-shaped fixing seat 21 into the bottom chamber away from the engaging slot, and rotatably disposed on the central rod 24, where a swivel nut 30 is sleeved on the bolt 29 and fixedly disposed on the fan-shaped fixing seat 21 at a position away from the engaging slot.

In one embodiment, as shown in FIGs. 3, 4 and 5, each connecting component includes: a bottom connecting seat 31 having a top end hinged to a bottom end of the fan-shaped fixing seat 21 through two spring rods 32 symmetrically arranged, and a bottom end on which the corresponding silicon wafer holder 12 is disposed; an engaging slot 33 provided in and running through the bottom connecting seat 31; a rotatable rod 34 having a middle segment provided as a square rod fitly and slidably connected into the engaging slot 33, and two ends rotatably disposed on a bow-shaped mounting bracket 35having an end away from the rotatable rod 34 extending into the bottom chamber and connected to the central rod 24; and paddles 36 vertically disposed at two ends of the rotatable rod 34.

In one embodiment, as shown in FIG. 5, a puller is provided on the limit plate 22, and a rotatable handle is provided on the bolt 29.

In one embodiment, in the process of depositing passivation films on the front face and the back face of the N-type silicon wafer, the passivation film deposited on the front face is a front passivation film consisting of an aluminum oxide film 4 and a front silicon nitride film 5 in superposition. The aluminum oxide passivation film is deposited by an autocatalytic reaction of trimethylaluminum and water, and has a thickness controlled between 3nm to 15nm; the silicon nitride passivation film is formed by ionization deposition of silane and ammonia in a PECVD manner, and the thickness of the front passivation film is controlled between 60nm to 100nm. The passivation film deposited on the back face is a back passivation film 9 consisting of a back silicon nitride film, and has a thickness controlled between 70nm to 110nm.

In one embodiment, in the process of printing and sintering, silver aluminum paste printed positive electrode silver-aluminum grid lines 6 are used on the front face of the N-type silicon wafer, while silver paste printed negative electrode silver grid lines 10 are used on the back face of the N-type silicon wafer, and then drying and sintering are performed to form an N-type TOPCon cell. The silver aluminum paste can form good metal contact with the lightly-doped region, while the silver paste can be sintered into a polysilicon layer to form good passivation metal contact, where the sintering temperature is between 500°C to 900°C.

### Third embodiment

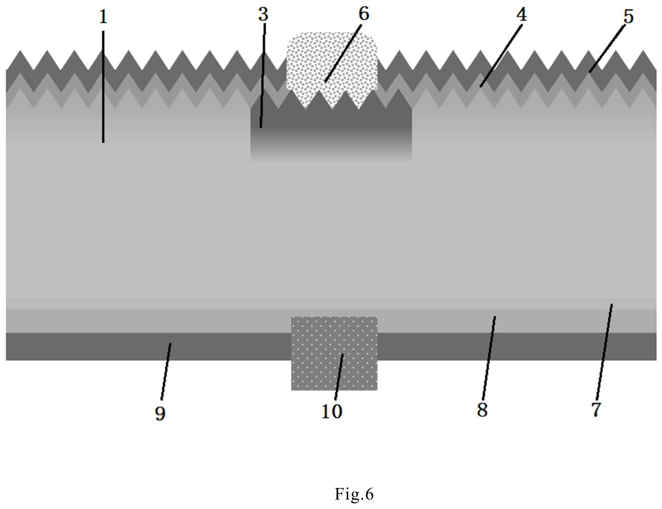

As shown in FIG. 6, this embodiment provides an N-type TOPCon cell, which is an N-type TOPCon cell being obtained by the preparation method for an N-type TOPCon cell according to the above embodiment.

In one embodiment, the N-type TOPCon cell comprises an N-type silicon wafer 1, a tunneling silicon oxide thin film layer 7, a doped polysilicon layer 8 and a back passivation film 9 are sequentially disposed on a back face of the N-type silicon wafer 1, the tunneling silicon oxide thin film layer 7 has a thickness less than 2nm, the doped polysilicon layer 8 has a thickness between 20nm and 200nm, and the back passivation film 9 has a thickness between 70nm and 110nm.

In one embodiment, a front face of the N-type silicon wafer 1 comprises a lightly-doped region 3, the lightly-doped region 3 has a sheet resistance between 70Ω/m and 120Ω/m; and the front face of the N-type silicon wafer 1 further comprises a front passivation film, the front passivation film is formed by an aluminum oxide film 4 and a front silicon nitride film 5 in superposition, and has a thickness between 60nm and 100nm.

In one embodiment, the N-type TOPCon cell further comprises silver-aluminum grid lines 6 disposed on the front face of the N-type silicon wafer 1, and silver grid lines 10 disposed on the back face of the N-type silicon wafer 1.

Obviously, the above embodiments are provided merely for clarity of illustration and are not intended to limit the implementations. For any one of ordinary skill in the art, other changes or alterations in different forms may be made on the basis of the above description. It is not necessary and cannot be exhaustive here. The obvious changes or alterations resulting therefrom are still within the protection scope of the present disclosure.

## Claims

1. A preparation method for an N-type tunnel oxide passivated contact (TOPCon) cell, comprising:
step 1: texturing an N-type silicon wafer with an alkaline solution, so that weight reduction of the N-type silicon wafer is controlled between 0.25g and 0.45g, and a surface reflectivity of the silicon wafer is controlled between 7% and 10%;
step 2: performing boron diffusion and laser lightly-doping on a front face of the N-type silicon wafer to form a lightly-doped region, and performing re-diffusion to form a front mask;
step 3: polishing a back face of the N-type silicon wafer;
step 4: performing three-in-one multi-layer thin film deposition on the back face of the N-type silicon wafer, to grow a tunneling silicon oxide thin film layer, a doped amorphous silicon thin film layer and a back mask, wherein the tunneling silicon oxide thin film layer has a thickness less than 2nm, the amorphous silicon thin film layer has a thickness between 50nm and 200nm, and the back mask has a thickness between 5nm and 30nm;
step 5: performing high-temperature annealing under a preset high-temperature condition to form a doped polysilicon layer and activate doped phosphorus;
step 6: cleaning the front mask on the front face and the back mask on the back face of the N-type silicon wafer;
step 7: depositing passivation films on the front face and the back face of the N-type silicon wafer; and
step 8: printing and sintering.

2. The preparation method according to claim 1, wherein the process of performing re-diffusion to form the front mask in step 2 comprises:
loading the textured N-type silicon wafer into a quartz boat, and pushing the quartz boat into a diffusion furnace quartz furnace tube with an internal temperature between 800°C and 900°C, wherein the diffusion furnace quartz furnace tube adopts a low-pressure diffusion mode;
introducing O₂ at a flow rate of 1000sccm to 5000sccm, and performing pre-oxidation for 100s to 500s before deposition;
heating up to 850°C to 900°C, and vacuumizing by a vacuum pump to enable a low-pressure state of the diffusion furnace quartz furnace tube at an atmosphere below 100mbar;
introducing BCl₃ at a flow rate of 50sccm to 500sccm and O₂ at a flow rate of 200sccm to 2000sccm to perform first boron source deposition for 100s to 500s;
introducing BCl₃ at a flow rate of 60sccm to 600sccm and O₂ at a flow rate of 300sccm to 3000sccm to perform second boron source deposition for 100s to 500s;
heating up to 950°C to 1050°C, and performing driving in for 500s to 2000s;
introducing 1L to 10L of nitrogen to provide a back pressure when the driving in is finished;
cooling and discharging: taking the quartz boat out of the diffusion furnace quartz furnace tube when the temperature is reduced to 700°C to 800°C; and
wafer removal: removing the N-type silicon wafer from the quartz boat;
wherein a sheet resistance is controlled between 90Ω/m and 160Ω/m.

3. The preparation method according to claim 1, wherein in the laser lightly-doping process in step 2, a laser device performs processing on a printed grid line region with boron atoms formed by diffusion to form a lightly-doped region, wherein a laser wavelength is controlled between 500nm and 1100nm, a laser power is controlled between 30W and 100W, a laser processing speed is between 10m/s and 50m/s, a laser width acting on the printed grid line region is between 50µm and 100µm, and a laser lightly-doped region has a sheet resistance between 70Ω/m and 120Ω/m; and
the process of performing re-diffusion to form the front mask comprises:
loading the textured N-type silicon wafer into a quartz boat, and pushing the quartz boat into a diffusion furnace quartz furnace tube with an internal temperature between 950°C and 1100°C, wherein the diffusion furnace quartz furnace tube adopts a low-pressure diffusion mode, and vacuumizing by a vacuum pump to enable a low-pressure state of the diffusion furnace quartz furnace tube at an atmosphere below 100mbar;
introducing O₂ at a flow rate of 10000sccm to 50000sccm and depositing for 3000s to 6000s, and performing oxidation to form a front mask with a thickness between 60nm and 120nm;
introducing 1L to 20L of nitrogen when the forming a front mask is finished to provide a back pressure;
cooling and discharging: taking the quartz boat out of the diffusion furnace quartz furnace tube when the temperature is reduced to 700°C to 800°C; and
wafer removal: removing the N-type silicon wafer from the quartz boat.

4. The preparation method according to claim 1, wherein in step 3, 2 to 3 parts of alkali metal hydroxide solution with a mass fraction of 40% to 60% and 1 part of polishing additive are used to polish the back face of the N-type silicon wafer at a temperature between 50°C and 70°C for 100s to 300s; and
the lightly-doped region on the front face of the N-type silicon wafer is protected by the front mask from being polished.

5. The preparation method according to any one of claims 1 to 4, wherein in step 4, laughing gas at a flow rate of 5000sccm to 15000sccm is introduced into a tubular plasma enhanced chemical vapor deposition (PECVD) furnace with a low-frequency power of 20KHz to 50KHz at a temperature between 300°C and 500°C, and ionized into plasma to oxidize the back face of the N-type silicon wafer to form a silicon dioxide layer with a thickness controlled between 0.5nm and 2.5nm; and in the process of depositing the doped amorphous silicon thin film layer on the back face, a tubular PECVD furnace with a low-frequency power of 20KHz to 50KHz is at a temperature between 300°C and 500°C, and has silane at a flow rate of 500sccm to 5000sccm and phosphane at a flow rate of 100sccm to 5000sccm, while hydrogen is introduced simultaneously as a catalyst gas for preparation of the doped amorphous silicon thin film layer, wherein the phosphorus doping concentration is between 1E19/cm³ and 1E21/cm³, and the amorphous silicon thin film layer has a thickness between 20nm and 200nm.

6. The preparation method according to any one of claims 1 to 4, wherein in step 6, an HF solution with a mass fraction of 30% to 60% is used in a cleaning device for cleaning to remove the front mask on the front face and the back mask on the back face of the N-type silicon wafer, wherein the cleaning is performed at a temperature between 20°C and 50°C for 100s to 500s; and the cleaning device comprises an ultrasonic cleaning tank, a plurality of turbulent type cleaning units are removably disposed at an opening end of the ultrasonic cleaning tank, and two silicon wafer holders are disposed oppositely on each turbulent type cleaning unit through fixing components.

7. The preparation method according to claim 6, wherein each turbulent type cleaning unit comprises: a cleaning seat, comprising: notches uniformly arranged at a side end of the cleaning seat for easy engagement of the fixing components, movable beams arranged symmetrically at a top end of the cleaning seat, a movable trolley disposed at an end of each movable beam away from the cleaning seat, and a track for easy movement of the movable trolley and disposed at the opening end of the ultrasonic cleaning tank; a drive motor disposed at the top end of the cleaning seat; and a drum opened at a bottom end; wherein an output end of the drive motor passes through the cleaning seat to be connected to a top end of the drum, and a surface of the drum is provided with hollow holes uniformly distributed and scroll plates spirally arranged.

8. The preparation method according to claim 7, wherein each fixing component comprises: a fan-shaped fixing seat, wherein an engaging slot is provided on a top end of the fan-shaped fixing seat for easy engagement of the side end of the cleaning seat, a limit plate covers an opening end of the engaging slot and is engaged with the top end of the cleaning seat, and each silicon wafer holder is disposed at a bottom end of the fan-shaped fixing seat through the corresponding connecting component; an action chamber in the fan-shaped fixing seat and consisting of a bottom chamber and side chambers, wherein the bottom chamber is located at a bottom of the engaging slot, two side chambers are symmetrically arranged taking the engaging slot as the center, and two side mounting shells are symmetrically disposed on the fan-shaped fixing seat and in communication with the side chambers; a central rod in the bottom chamber and connected to the connecting component which extends into the bottom chamber; two side connecting rods hinged at two ends of the central rod, respectively; a clamping rod bent at an obtuse angle in each side chamber, wherein one end of the clamping rod is rotatably disposed in the action chamber through a rotation shaft, while the other end of the clamping rod is provided with an engaging block matched with the notches, and extends into the corresponding side mounting shell; and a bolt extending from the fan-shaped fixing seat into the bottom chamber away from the engaging slot, and rotatably disposed on the central rod, wherein a swivel nut is sleeved on the bolt and fixedly disposed on the fan-shaped fixing seat at a position away from the engaging slot.

9. The preparation method according to claim 7, wherein each connecting component comprises: a bottom connecting seat having a top end hinged to a bottom end of the fan-shaped fixing seat through two spring rods symmetrically arranged, and a bottom end on which the corresponding silicon wafer holder is disposed; an engaging slot provided in and running through the bottom connecting seat; a rotatable rod having a middle segment provided as a square rod fitly and slidably connected into the engaging slot, and two ends rotatably disposed on a bow-shaped mounting bracket with an end away from the rotatable rod extending into the bottom chamber and connected to the central rod; and paddles vertically disposed at two ends of the rotatable rod.

10. The preparation method according to claim 8, wherein a puller is provided on the limit plate, and a rotatable handle is provided on the bolt.

11. A preparation method for an N-type tunnel oxide passivated contact (TOPCon) cell, comprising:
texturing an N-type silicon wafer;
performing boron diffusion and laser lightly-doping on a front face of the N-type silicon wafer to form a lightly-doped region;
performing re-diffusion on the front face of the N-type silicon wafer to form a front mask;
polishing a back face of the N-type silicon wafer;
performing three-in-one multi-layer thin film deposition on the back face of the N-type silicon wafer, and growing a tunneling silicon oxide thin film layer, a doped amorphous silicon thin film layer and a back mask through one process step;
performing high-temperature annealing under a preset high-temperature condition to form a doped polysilicon layer and activate doped phosphorus;
cleaning the front mask on the front face and the back mask on the back face of the N-type silicon wafer;
depositing passivation films on the front face and the back face of the N-type silicon wafer; and
printing and sintering.

12. The preparation method according to claim 11, wherein the process of performing re-diffusion to form the front mask comprises:
introducing O₂ at a flow rate of 1000sccm to 5000sccm into an environment with a temperature between 800°C and 900°C to pre-oxidize the N-type silicon wafer for 100s to 500s;
introducing BCl₃ at a flow rate of 50sccm to 500sccm and O₂ at a flow rate of 200sccm to 2000sccm into an environment with a temperature between 850°C and 900 °C and an atmosphere below 100mbar, to perform first boron source deposition for 100s to 500s;
introducing BCl₃ at a flow rate of 60sccm to 600sccm and O₂ at a flow rate of 300sccm to 3000sccm to perform second boron source deposition for 100s to 500s;
performing driving in for 500s to 2000s in an environment with a temperature between 950°C and 1050°C; and
introducing 1L to 10L of nitrogen to provide a back pressure.

13. The preparation method according to claim 11, wherein the laser lightly-doping process comprises:
performing laser lightly-doping processing on a printed grid line region with boron atoms formed by diffusion, to form a lightly-doped region, wherein a laser wavelength is between 500nm and 1100nm, a laser power is between 30W and 100W, a laser processing speed is between 10m/s and 50m/s, and a laser width acting on the printed grid line region is between 50µm and 100µm; and
the process of performing re-diffusion to form the front mask comprises:
introducing O₂ at a flow rate of 10000sccm to 50000sccm into an environment with a temperature between 950°C and 1100°C and an atmosphere below 100mbar, and depositing for 3000s to 6000s to form the front mask; and
introducing 1L to 20L of nitrogen to provide a back pressure.

14. The preparation method according to any one of claims 11 to 13, wherein the process of polishing the back face of the N-type silicon wafer comprises:
polishing the back face of the N-type silicon wafer with 2 to 3 parts of alkali metal hydroxide solution with a mass fraction of 40% to 60% and 1 part of polishing additive, wherein the polishing is performed at a temperature between 50°C and 70°C for 100s to 300s.

15. The preparation method according to any one of claims 11 to 13, wherein the process of growing the tunneling silicon oxide thin film layer, the doped amorphous silicon thin film layer and the back mask through one process step comprises:
preparing a tunneling silicon oxide thin film layer, a doped amorphous silicon thin film layer and a back mask in one process step by Plasma Enhanced Chemical Vapor Deposition (PECVD).

16. The preparation method according to claim 15, wherein the process of growing the tunneling silicon oxide thin film layer, the doped amorphous silicon thin film layer and the back mask through one process step by PECVD comprises:
introducing laughing gas at a flow rate of 5000sccm to 15000sccm into a PECVD device at a temperature between 300°C and 500°C, and ionizing the laughing gas into plasma to oxidize the back face of the N-type silicon wafer to form a tunneling silicon oxide thin film layer;
introducing hydrogen into the PECVD device at a temperature between 300°C and 500°C and having silane at a flow rate of 500sccm to 5000sccm and phosphane at a flow rate of 100sccm to 5000sccm, to form a doped amorphous silicon thin film layer; and
introducing laughing gas at a flow rate of 2000sccm to 10000sccm, and silane at a flow rate of 500sccm to 5000sccm into the PECVD device at a temperature between 300°C and 500°C, to form a back mask.

17. The preparation method according to any one of claims 11 to 13, wherein the process of cleaning the front mask on the front face and the back mask on the back face of the N-type silicon wafer comprises:
using an HF solution with a mass fraction of 30% to 60% in a cleaning device for cleaning to remove the front mask on the front face and the back mask on the back face of the N-type silicon wafer, wherein the cleaning is performed at a temperature between 20°C and 50°C for 100s to 500s; and wherein the cleaning device comprises an ultrasonic cleaning tank, a plurality of turbulent type cleaning units are removably disposed at an opening end of the ultrasonic cleaning tank, and two silicon wafer holders are disposed oppositely on each turbulent type cleaning unit.

18. An N-type TOPCon cell, said N-type TOPCon cell being obtained by the preparation method for an N-type TOPCon cell according to any one of claims 1 to 17.

19. The N-type TOPCon cell according to claim 18, wherein the N-type TOPCon cell comprises an N-type silicon wafer, a tunneling silicon oxide thin film layer, a doped polysilicon layer and a back passivation film are sequentially disposed on a back face of the N-type silicon wafer, the tunneling silicon oxide thin film layer has a thickness less than 2nm, the doped polysilicon layer has a thickness between 20nm and 200nm, and the back passivation film has a thickness between 70nm and 110nm.

20. The N-type TOPCon cell according to claim 18 or 19, wherein a front face of the N-type silicon wafer comprises a lightly-doped region, the lightly-doped region has a sheet resistance between 70Ω/m and 120Ω/m; and
the front face of the N-type silicon wafer further comprises a front passivation film, the front passivation film is formed by an aluminum oxide film and a front silicon nitride film in superposition, and has a thickness between 60nm and 100nm.
